# EUROPEAN PATENT APPLICATION

(11) **EP 4 804 767 A1**
(43) Date of publication of application: **09.09.2026**
(21) Application number: 25213467.1
(22) Date of filing: 04.11.2025
(51) Int. Cl.: H10F 71/00, H10F 19/90, H10F 77/30, H10F 19/80

(54) **SEGMENTED SOLAR CELL AND PHOTOVOLTAIC MODULE**

(30) Priority: 04.03.2025 CN 202510251599
(71) Applicant: Shangrao Jinko Solar No.3 Intelligent Manufacturing Co., Ltd., Shangrao City, Jiangxi 333100 (CN); Zhejiang Jinko Solar Co., Ltd., Haining, Zhejiang (CN)
(72) Inventor: JIN, Jingsheng, Shangrao (CN); CUI, Wei, Shangrao (CN); ZHANG, Xinyu, Shangrao (CN)
(74) Representative: Balder IP Law, S.L.

(57) **Abstract**

The present disclosure relates to the field of photovoltaic technology, and provides a segmented solar cell and a photovoltaic module, which is at least beneficial to improving the efficiency of the photovoltaic module. The segmented solar cell is formed by cutting a whole solar cell, and includes: a cell body having a first main surface, an opposing second main surface, and a first side surface and a second side surface connecting the first main surface and the second main surface, respectively; a first passivation stack formed on the first side surface, a second passivation stack formed on the second side surface, and a third metal oxide layer formed on a surface of the second passivation stack away from the cell body. The first side surface is a cut surface formed by cutting the whole solar cell, and the second side surface is an uncut side surface.

## Description

### TECHNICAL FIELD

The present disclosure relates to the field of photovoltaic technology, and in particular to a segmented solar cell and a photovoltaic module.

### BACKGROUND

To solve problems such as power reduction and hot spots of photovoltaic modules caused by differences in electrical performance of solar cells, whole solar cells are designed to work at high currents, which, however, easily cause a significant loss due to resistance. In order to address the problem of significant power loss of whole solar cells, photovoltaic modules including half-cut and/or shingled solar cells have been developed in succession, winning increasing favor from module manufacturers and users.

However, both a half-cut photovoltaic module and a shingled photovoltaic module require cutting a whole solar cell into two or more segmented solar cells by using laser cutting technology. For the segmented solar cells formed after cutting, presence of mechanical damage caused in a cutting process and of dangling bonds on a cut surface leads to a decrease in the efficiency of the segmented solar cells after cutting, thereby reducing the power of the photovoltaic module.

### SUMMARY

Embodiments of the present disclosure provide a segmented solar cell and a photovoltaic module, which are at least beneficial to improving the efficiency of the photovoltaic module.

Some embodiments of the present disclosure provide a segmented solar cell formed by cutting a whole solar cell. The segmented solar cell includes: a cell body including a first main surface and an opposing second main surface, and a first side surface and a second side surface connecting the first main surface and the second main surface, respectively, where the first side surface refers to a cut surface formed by cutting the whole solar cell, and the second side surface refer to an uncut side surface; a first passivation stack formed on the first side surface, where the first passivation stack includes a first silicon oxide layer, a first silicon metal oxide layer, and a first metal oxide layer stacked along a first direction away from the cell body; and a second passivation stack formed on the second side surface, where the second passivation stack includes a second silicon oxide layer, a second silicon metal oxide layer, a second metal oxide layer, and a silicon nitride layer.

In some embodiments, the segmented solar cell further includes a third metal oxide layer formed on a surface of the second passivation stack away from the cell body, where the third metal oxide layer includes a metal element same as that in the first metal oxide layer.

In some embodiments, concentration of metal atoms per unit volume in the first metal oxide layer is less than or equal to concentration of metal atoms per unit volume in the third metal oxide layer.

In some embodiments, the second side surface is perpendicular to the first main surface or the second main surface; and the first side surface forms an acute angle with the first main surface and an obtuse angle with the second main surface.

In some embodiments, the first metal oxide layer has a first thickness at the acute angle and a second thickness at the obtuse angle, and the first thickness is greater than or equal to the second thickness.

In some embodiments, the second silicon oxide layer, the second silicon metal oxide layer, and the second metal oxide layer are further formed over the first main surface and stacked along a second direction away from the cell body; and the silicon nitride layer is further formed on the second main surface.

In some embodiments, the second silicon oxide layer formed on the first main surface has a thickness greater than a thickness of the second silicon oxide layer of the second passivation stack, the second silicon metal oxide layer formed over the first main surface has a thickness greater than a thickness of the second silicon metal oxide layer of the second passivation stack, and the second metal oxide layer formed over the first main surface has a thickness greater than a thickness of the second metal oxide layer of the second passivation stack; and/or the silicon nitride layer formed on the second main surface has a thickness greater than a thickness of the silicon nitride layer of the second passivation stack.

In some embodiments, the second silicon oxide layer has a thickness less than a thickness of the first silicon oxide layer; the second silicon metal oxide layer has a thickness less than a thickness of the first silicon metal oxide layer; and the second metal oxide layer has a thickness less than a thickness of the first metal oxide layer.

In some embodiments, the thickness of the first silicon oxide layer ranges from 1 nm to 10 nm; the thickness of the first silicon metal oxide layer ranges from 1 nm to 15 nm; the thickness of the first metal oxide layer ranges from 10 nm to 100 nm; the thickness of the second silicon oxide layer ranges from 0.5 nm to 5 nm; the thickness of the second silicon metal oxide layer ranges from 0.5 nm to 5 nm; and the thickness of the second metal oxide layer ranges from 1 nm to 60 nm.

In some embodiments, concentration of metal atoms per unit volume in second metal oxide layer is less than concentration of metal atoms per unit volume in the first metal oxide layer.

In some embodiments, the concentration of metal atoms per unit volume in the second metal oxide layer ranges from 0.9E23atoms/cm³ to 1.3E23atoms/cm³; and the concentration of metal atoms per unit volume in the first metal oxide layer ranges from 0.9E23atoms/cm³ to 1.3E23atoms/cm³.

Some embodiments of the present disclosure further provide a photovoltaic module, including: a plurality of segmented solar cells, where each segmented solar cell of the plurality of the segmented solar cells is the segmented solar cell as described in the above embodiments; connection components, where each connection component of the connection components is configured to connect two adjacent segmented solar cells of the plurality of the segmented solar cells; at least one encapsulant film configured to cover surfaces of the plurality of segmented solar cells; and at least one cover plate configured to cover at least one surface of the at least one encapsulant film away from the plurality of segmented solar cells.

The technical solutions provided in the embodiments of the present disclosure at least have the following advantages:

Embodiments of the present disclosure provide a segmented solar cell and a photovoltaic module, which are at least beneficial to improving the efficiency of the photovoltaic module. The segmented solar cell provided in some embodiments of the present disclosure is formed by cutting a whole solar cell, and includes a cell body having a first main surface, a second main surface, and a first side surface and second side surfaces connecting the first main surface and the second main surface, a first passivation stack formed on the first side surface, and a second passivation stack formed on at least one second side surface of the second side surfaces. The first side surface refers to a cut surface formed by cutting the whole solar cell, and the second side surfaces refer to uncut side surfaces. The segmented solar cell further includes a third metal oxide layer formed on the second passivation stack. In this way, the cut surface of the segmented solar cell formed by cutting the whole solar cell is passivated by the first passivation stack, and at least one uncut side surface of the segmented solar cell having mechanical damage and dangling bonds caused by cutting of wafer is passivated by the second passivation stack and the third metal oxide layer, which is beneficial to further improving the efficiency of the photovoltaic module.

### BRIEF DESCRIPTION OF THE DRAWINGS

One or more embodiments are exemplarily described by figures in corresponding accompanying drawings, and such exemplary description does not constitute a limitation on the embodiments. The figures in the accompanying drawings do not constitute a scale limitation unless otherwise stated. In order to more clearly illustrate technical solutions in the embodiments of the present disclosure or in the prior art, a brief introduction to the accompanying drawings required for the description of the embodiments or the prior art will be provided below. Obviously, the accompanying drawings in the following description are only some of the embodiments of the present disclosure, and those of ordinary skill in the art would also be able to derive other drawings from these drawings without making creative efforts.
FIG. 1 is a top view illustrating a whole solar cell provided in some embodiments of the present disclosure.
FIG. 2 is a top view illustrating two segmented solar cells formed by cutting the whole solar cell in FIG. 1.
FIG. 3 is a schematic diagram illustrating a sectional structure of the segmented solar cell in FIG. 2 along an AA1 direction.
FIG. 4 is a top view illustrating four segmented solar cells formed by cutting a whole solar cell provided in some embodiments of the present disclosure.
FIG. 5 is a schematic diagram illustrating another sectional structure of the segmented solar cell in FIG. 2 along the AA1 direction.
FIG. 6 is a schematic diagram illustrating yet another sectional structure of the segmented solar cell in FIG. 2 along the AA1 direction.
FIG. 7 is a schematic structural diagram illustrating a photovoltaic module provided in some embodiments of the present disclosure.

### Reference numerals in figures:

1-whole solar cell; 10-segmented solar cell; 100-cell body; 101-first main surface; 102-second main surface; 103-first side surface; 104-second side surface; 110-first passivation stack; 111-first silicon oxide layer; 112-first silicon metal oxide layer; 113-first metal oxide layer; 120-second passivation stack; 121-second silicon oxide layer; 122-second silicon metal oxide layer; 123-second metal oxide layer; 124-silicon nitride layer; 130-third metal oxide layer; 201-connection component; 202-encapsulant film; and 203-cover plate.

### DETAILED DESCRIPTION OF THE EMBODIMENTS

It can be known from the background art that the photoelectric conversion efficiency of segmented solar cells needs to be improved.

Currently, to reduce a large power loss of a whole solar cell, laser cutting technology is employed to cut the whole solar cell into two or more small segmented solar cells, and then the segmented solar cells are connected in series by means of a conductive ribbon, where current of the segmented solar cells in series is lower than current of the whole solar cell, and a decrease in the current of the segmented solar cells may reduce a power loss of a photovoltaic module. However, mechanical damage caused in a cutting process, and presence of dangling bonds on a cut surface leads to a decrease in the efficiency of the segmented solar cells after cutting, thereby reducing the power of the photovoltaic module.

For a cut surface of the segmented solar cell generated by cutting, a passivation layer may be formed on the cut surface to prevent the decrease in the photoelectric conversion efficiency of the segmented solar cell caused by cutting. However, the presence of dangling bonds on an uncut side surface of the segmented solar cell is ignored, which easily leads to the reduction in the power of the photovoltaic module.

Since the whole solar cell is made of a wafer and the wafer is obtained by cutting a silicon rod, a periphery of the wafer needs to be cut to form a rectangular whole solar cell that meets arrangement requirements for solar cells, and cutting of the wafer leads to mechanical damage to the periphery of the whole solar cell and further generation of dangling bonds thereon. Thus, when forming segmented solar cells by cutting a whole solar cell, dangling bonds also exist on uncut side surfaces of the segmented solar cells, such that it is difficult to improve the efficiency of the photovoltaic module.

Embodiments of the present disclosure provide a segmented solar cell and a photovoltaic module, which are at least beneficial to improving the efficiency of the photovoltaic module. The segmented solar cell provided in some embodiments of the present disclosure is formed by cutting a whole solar cell, and includes a cell body having a first main surface, a second main surface, and a first side surface and second side surfaces connecting the first main surface and the second main surface, a first passivation stack formed on the first side surface, and a second passivation stack formed on at least one second side surface of the second side surfaces. The first side surface refers to a cut surface formed by cutting the whole solar cell, and the second side surfaces refer to uncut side surfaces. In this way, the cut surface of the segmented solar cell formed by cutting the whole solar cell is passivated by the first passivation stack, and at least one uncut side surface of the segmented solar cell having mechanical damage and dangling bonds caused by cutting of wafer is passivated by the second passivation stack, which is beneficial to further improving the efficiency of the photovoltaic module.

In the description of the embodiments of the present disclosure, technical terms "first" and "second" are only used to distinguish different objects, and should not be construed as indicating or implying relative importance or implicitly indicating the number, a specific order, or hierarchical relationship of technical features indicated.

In the description of the embodiments of the present disclosure, "a plurality of" means two or more, unless expressly specified otherwise.

When the term "embodiment" is referred to herein, it means that specific features, structures or characteristics described in combination with the embodiment are included in at least one embodiment of the present disclosure. When this phrase occurs at various positions in the specification, it neither necessarily refers to the same embodiment, nor refers to an independent or alternative embodiment mutually exclusive to other embodiments. Those skilled in the art understand both explicitly and implicitly that the embodiments described herein can be combined with other embodiments.

In the description of the embodiments of the present disclosure, the term "and/or" represents merely an association relationship describing associated objects, indicating that there may be three types of relationships, for example, A and/or B, which means three types of situation, that is, the existence of A alone, the existence of both A and B, and the existence of B alone. In addition, the character "/" herein generally indicates that the associated objects are in an "or" relationship.

In the description of the embodiments of the present disclosure, technical terms "center", "longitudinal", "lateral", "length", "width", "thickness", "upper", "lower", "front", " rear", "left", "right", "vertical", "horizontal", "top", "bottom", "inner", "outer", "clockwise", "counterclockwise", "axial", "radial", "circumferential", etc. indicate azimuthal or positional relations based on those shown in the accompanying drawings only for ease of description of the embodiments of the present disclosure and for simplicity of description, and are not intended to indicate or imply that the referenced device or element must have a particular orientation and be constructed and operative in a particular orientation, and thus may not be interpreted as a limitation on the embodiments of the present disclosure.

In the accompanying drawings corresponding to the embodiments of the present disclosure, a thickness and area of a layer are enlarged for better understanding and description. When it is described that a component is disposed on another component or on a surface of another component, the component may be "directly" disposed on the surface of the other component, or a third component may exist between the two components. On the contrary, when it is described that a component is disposed on a surface of another component or another component is formed or disposed on a surface of a component, it means that there is no third component between the two components. Additionally, when it is described that a component is "substantially" formed on another component, it means that the component neither is formed on a full surface (or a front surface) of the other component, nor is formed on a partial edge of the entire surface.

In the description of the embodiments of the present disclosure, when a component "includes" another component, unless otherwise stated, other components are not excluded, and other components may be further included.

The terms used in the description of the various embodiments mentioned herein are only intended to describe specific embodiments and are not intended to limit. As used in the description of the various embodiments and the appended claims, the term "component" is also intended to include the plural form, unless the context clearly indicates otherwise.

Embodiments of the present disclosure will be described in detail below with reference to accompanying drawings. However, those of ordinary skill in the art may understand that in each embodiment of the present disclosure, many technical details have been put forward in order to make readers better understand the present disclosure. However, even without these technical details and various changes and modifications based on the embodiments below, technical solutions required to be protected by the present disclosure may be implemented.

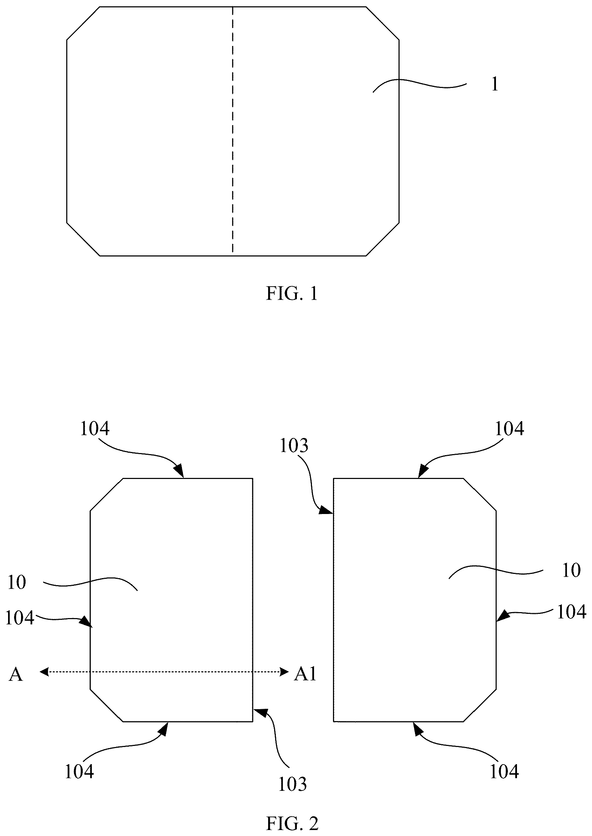

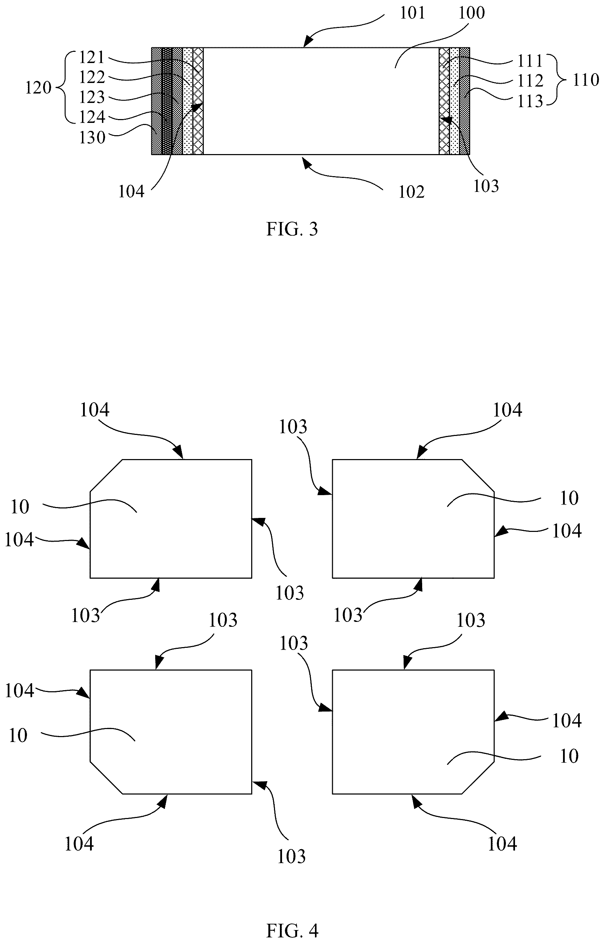

FIG. 1 is a top view illustrating a whole solar cell provided in some embodiments of the present disclosure; FIG. 2 is a top view illustrating two segmented solar cells formed by cutting the whole solar cell in FIG. 1; and FIG. 3 is a schematic diagram illustrating a sectional structure of the segmented solar cell in FIG. 2 along an AA1 direction. In FIG. 1, the dashed line is a cutting line, and the whole solar cell is cut along the cutting line in the cutting process.

With reference to FIGS. 1 to 3, a segmented solar cell 10 is provided in some embodiments of the present disclosure, the segmented solar cell 10 is formed by cutting a whole solar cell 1, and the segmented solar cell 10 includes: a cell body 100, a first passivation stack 110, and a second passivation stack 120.

The cell body 100 includes a first main surface 101 and a second main surface 102 opposite to each other, and a first side surface 103 and second side surfaces 104 connecting the first main surface 101 and the second main surface 102, where the first side surface 103 is a cut surface formed by cutting the whole solar cell 1, and the second side surfaces 104 are uncut side surfaces.

The first passivation stack 110 is formed on the first side surface 103, and the first passivation stack 110 includes a first silicon oxide layer 111, a first silicon metal oxide layer 112, and a first metal oxide layer 113 sequentially stacked in a direction away from the cell body 100.

The second passivation stack 120 is formed on the second side surface 104, and the second passivation stack 120 includes a second silicon oxide layer 121, a second silicon metal oxide layer 122, a second metal oxide layer 123, and a silicon nitride layer 124 sequentially stacked in the direction away from the cell body 100. FIG. 3 exemplarily shows that the second passivation stack 120 is formed on a second side surface 104. In some other embodiments, the segmented solar cell 10 may include a plurality of second passivation stacks 120, and each second passivation stack 120 is formed on a respective second side surface 104 of the second side surfaces 104. In other words, in practice, the segmented solar cell 10 may include at least one second passivation stack 120 formed on at least one corresponding second side surface 104, respectively.

In some embodiments, the segmented solar cell 10 further includes a third metal oxide layer 130. The third metal oxide layer 130 is formed on a surface of the second passivation stack 120 away from the cell body 100, and a metal element in the third metal oxide layer 130 is the same as a metal element in the first metal oxide layer 113.

The segmented solar cell 10 provided in the embodiments of the present disclosure is formed by cutting the whole solar cell 1, the segmented solar cell 10 includes the cell body 100, the first main surface 101 of the cell body 100 is one of a front surface and a back surface thereof, and the second main surface 102 is the other of the front surface and the back surface; the first side surface 103 is the cut surface of the segmented solar cell 10 formed by cutting the whole solar cell 1, the second side surface 104 is the uncut side surface from the whole solar cell 1, the first side surface 103 is provided with the first passivation stack 110 composed of the first silicon oxide layer 111, the first silicon metal oxide layer 112, and the first metal oxide layer 113, the first silicon oxide layer 111 chemically passivates the cut surface (i.e., the first side surface 103), and oxygen atoms thereof saturate the dangling bonds on the cut surface to reduce a defect state density of the cut surface and reduce a carrier recombination probability by minimizing a recombination center on the cut surface; the metal element in the first metal oxide layer 113 provides high-density fixed charges, which generates a large electric field, achieves a good field passivation effect on the cut surface, reduces a concentration of minority carriers at the cut surface, and further reduces a recombination probability of majority carriers and minority carriers at the cut surface; and the first silicon metal oxide layer 112 serves as a transition layer between the first silicon oxide layer 111 and the first metal oxide layer 113, which improves a lattice matching degree at an interface where the first silicon oxide layer 111, the first silicon metal oxide layer 112, and the first metal oxide layer 113 come into contact with each other sequentially, prevents pores generation and dislocation at the contact interface, enhances the uniformity of the first passivation stack 110, and further improves an passivation effect of the first passivation stack 110 on the cut surface. The second side surface 104 is further provided with the second passivation stack 120 similar to the first passivation stack 110; and the second silicon oxide layer 121, the second silicon metal oxide layer 122, and the second metal oxide layer 123 in the second passivation stack 120 have a same mechanism of action as the first passivation stack 110, which enables to passivate the side surface of the segmented solar cell 10 not cut from the whole solar cell 1, and further reduces an impact of mechanical damage and dangling bonds caused by cutting of the wafer on the efficiency of the segmented solar cell 10. The second passivation stack 120 further includes the silicon nitride layer 124, and the silicon nitride layer 124 has advantages of a high specific strength, a high specific modulus, high temperature resistance, oxidation resistance, wear resistance, and thermal shock resistance, and is capable of protecting the second passivation stack 120 from the influence of other processes. The third metal oxide layer 130 is formed on a surface of the second passivation stack 120 away from the cell body 100, and a metal element in the third metal oxide layer 130 is the same as a metal element in the first metal oxide layer 113, such that the third metal oxide layer 130 and the first metal oxide layer 113 may be formed by means of a same process step, and the third metal oxide layer 130 further improves the passivation effect of the side surface of the segmented solar cell 10 not cut from the whole solar cell 1, which is beneficial to further improving the efficiency of the segmented solar cell.

In FIGS. 1 and 2, an example where the whole solar cell 1 is cut along one cutting line to form two segmented solar cells 10 does not limit the number of the segmented solar cells 10 formed by cutting the whole solar cell 1.

FIG. 4 is a top view illustrating four segmented solar cells formed by cutting a whole solar cell provided in some embodiments of the present disclosure.

With reference to FIG. 4, the whole solar cell may be divided into four segmented solar cells 10 by two "cross-shaped" cutting lines, and each of the segmented solar cells 10 correspondingly has two first side surfaces 103 and two second side surfaces 104.

In practical applications, the number and size of the segmented solar cells 10 formed by cutting the whole solar cell 1 may be adjusted according to requirements, and for example, the single whole solar cell 1 may also be cut into 3, 5, 6, 7, 8, or 10 segmented solar cells, etc. The number and positions of corresponding cutting lines may be adjusted according to the actually required number and size of the segmented solar cells 10.

In some embodiments, the periphery of the whole solar cell 1 is chamfered to prevent the risk of fragmentation caused by stress concentration at corners of the whole solar cell 1 in a manufacturing process.

In some embodiments, the whole solar cell 1 and the corresponding segmented solar cells 10 may belong to a monocrystalline silicon solar cell, a polycrystalline silicon solar cell, an amorphous silicon solar cell or a multi-compound solar cell, where the multi-compound solar cell may specifically be a cadmium sulfide solar cell, a gallium arsenide solar cell, a copper indium selenide solar cell or a perovskite solar cell.

In some embodiments, the whole solar cell 1 and the corresponding segmented solar cells 10 may belong to any one of a passivated emitter and rear cell (PERC), a passivated emitter and rear totally-diffused (PERT) cell, a tunnel oxide passivated contact (TOPCon) cell, a heterojunction technology (HIT/HJT) cell or a back contact (BC) cell. The BC cell may be an interdigitated back contact (IBC) cell, a hybrid passivated back contact (HPBC) cell, a TOPCon back contact (TBC) cell combining TOPCon technology and IBC technology, or a heterojunction back contact (HBC) cell combining HIT/HJT technology and IBC technology, and further may be a back contact cell of any other type.

In FIG. 3, both the first main surface 101 and the second main surface 102 are shown as flat surfaces for illustration, and in some other embodiments, at least one of the first main surface 101 and the second main surface 102 may have a textured structure, such as a pyramid-shaped textured structure, where the textured structure enhances absorption and utilization of incident light by the cell body 100, which is beneficial to improving the photoelectric conversion efficiency of the segmented solar cell 10.

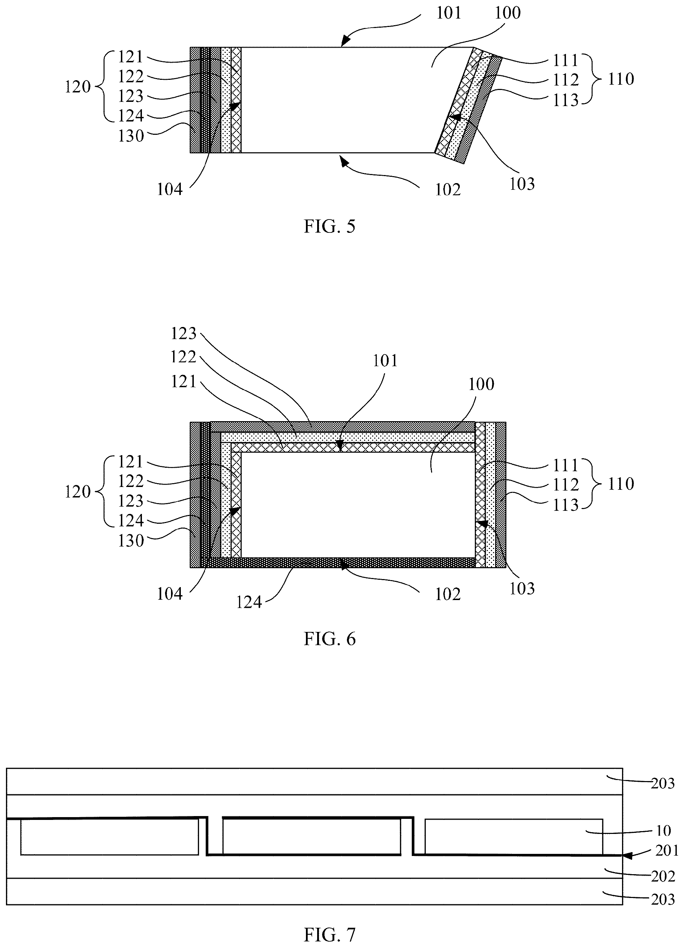

FIG. 5 is a schematic diagram illustrating another sectional structure of the segmented solar cell in FIG. 2 along the AA1 direction.

With reference to FIG. 5, in some embodiments, the second side surface 104 is perpendicular to the first main surface 101 or the second main surface 102; and the first side surface 103 forms an acute angle with the first main surface 101 and an obtuse angle with the second main surface 102. The second side surface 104 is a side surface formed by cutting the wafer, so the second side surface 104 is approximately perpendicular to the first main surface 101 or the second main surface 102; and during the process of cutting the whole solar cell 1 into a plurality of the segmented solar cells 10, a cutting angle may be adjusted such that an acute angle is formed between the first side surface 103 and the first main surface 101 and an obtuse angle is formed between the first side surface 103 and the second main surface 102; and in this way, the first side surface 103 may be close to an fcc (111) crystal plane of the segmented solar cell 10, and compared with other crystal planes, the fcc (111) crystal plane has a minimum atomic arrangement density and a minimum covalent bond surface density.

The acute angle may range from 45° to 50°, and for example, the acute angle may be 46°, 47°, 48°, or 49° to minimize the atomic arrangement density of the first side surface 103 and maximize the capability of the first passivation stack 110 to saturate the dangling bonds on the first side surface 103, so as to further improve the passivation effect of the first passivation stack 110 on the first side surface 103, further reduce a probability of carrier recombination on the first side surface 103, extend the lifetime of the carriers, and further improve the photoelectric conversion efficiency of the segmented solar cell 10.

When the first side surface 103 forms an acute angle with the first main surface 101 and an obtuse angle with the second main surface 102, in a subsequent process of forming the first passivation stack 110, one side of the first side surface 103 close to the acute angle first comes into contact with a deposition gas source than one side of the first side surface 103 close to the obtuse angle. Therefore, in a subsequent process of forming the first passivation stack 110, a thickness of the first metal oxide layer 113 on one side close to the acute angle may be greater than or equal to a thickness of the first metal oxide layer 113 on one side close to the obtuse angle; similarly, a thickness of the first silicon metal oxide layer 112 on one side close to the acute angle may be greater than or equal to a thickness of the first silicon metal oxide layer 112 on one side close to the obtuse angle; and similarly, a thickness of the first silicon oxide layer 111 on one side close to the acute angle may be greater than or equal to a thickness of the first silicon oxide layer 111 on one side close to the obtuse angle.

In a direction perpendicular to the first side surface 103, the thickness of the first metal oxide layer 113 on one side close to the acute angle is a first thickness, and the thickness of the first metal oxide layer 113 on one side close to the obtuse angle is a second thickness, where a difference between the first thickness and the second thickness may range from 0 nm to 5 nm, such as 0 nm, 0.5 nm, 0.8 nm, 1 nm, 1.3 nm, 1.6 nm, 1.8 nm, 2 nm, 2.5 nm, 3 nm, 3.4 nm, 3.6 nm, 4 nm, 4.55 nm, or 5 nm.

Similarly, for the first silicon oxide layer 111, a difference between the thickness of the first silicon oxide layer 111 on one side close to the acute angle and the thickness of the first silicon oxide layer 111 on one side close to the obtuse angle may also range from 0 nm to 5 nm, such as 0 nm, 0.5 nm, 0.8 nm, 1 nm, 1.3 nm, 1.6 nm, 1.8 nm, 2 nm, 2.5 nm, 3 nm, 3.4 nm, 3.6 nm, 4 nm, 4.55 nm, or 5 nm; and for the first silicon metal oxide layer 112, a difference between the thickness of the first silicon metal oxide layer 112 on one side close to the acute angle and the thickness of the first silicon metal oxide layer 112 on one side close to the obtuse angle may also from 0 nm to 5 nm, such as 0 nm, 0.5 nm, 0.8 nm, 1 nm, 1.3 nm, 1.6 nm, 1.8 nm, 2 nm, 2.5 nm, 3 nm, 3.4 nm, 3.6 nm, 4 nm, 4.55 nm, or 5 nm.

A thickness of the first silicon oxide layer 111 at any position in the direction perpendicular to the first side surface 103 may range from 1 nm to 10 nm, such as 1 nm, 1.3 nm, 2 nm, 2.5 nm, 3 nm, 3.6 nm, 4 nm, 4.5 nm, 5 nm, 5.5 nm, 6 nm, 6.5 nm, 7 nm, 7.5 nm, 8 nm, 8.6 nm, 9 nm, 9.4 nm, or 10 nm.

The first silicon oxide layer 111 may be made of an SiₐO_{b} material, and a/b ∈ [1.5, 49], where a/b represents a ratio of content of silicon to content of oxygen in the first silicon oxide layer 111.

A thickness of the first silicon metal oxide layer 112 at any position in the direction perpendicular to the first side surface 103 may range from 1 nm to 15 nm, such as 1 nm, 1.3 nm, 2 nm, 2.5 nm, 3 nm, 3.6 nm, 4 nm, 4.5 nm, 5 nm, 5.5 nm, 6 nm, 6.5 nm, 7 nm, 7.5 nm, 8 nm, 8.6 nm, 9 nm, 9.4 nm, 10.5 nm, 11 nm, 11.5 nm, 12 nm, 12.5 nm, 13 nm, 13.6 nm, 14 nm, 14.4 nm, or 15 nm.

The first silicon metal oxide layer 112 may be made of an SiAlᵢOⱼ material, and i/j ∈ [0.04, 1.31], where i/j represents a content ratio of an element aluminum to an element oxygen in the first silicon metal oxide layer 112.

A thickness of the first metal oxide layer 113 at any position in the direction perpendicular to the first side surface 103 may range from 10 nm to 100 nm, such as 10 nm, 22 nm, 33 nm, 45 nm, 53 nm, 66 nm, 74 nm, 85 nm, 96 nm, or 100 nm.

The first metal oxide layer 113 may be made of an XₘOₙ material, and m/n ∈ [1, 1.2], where m/n represents a content ratio of a metal element X to an element oxygen in the first metal oxide layer 113. The metal element X may be at least one of an element aluminum (Al), an element titanium (Ti), an element zinc (Zn), an element zirconium (Zr), an element hafnium (Hf), an element molybdenum (Mo), an element tungsten (W) or an element nickel (Ni), the above metal elements cause the first metal oxide layer 113 to have high-density fixed charges, and the high-density fixed charges generate a large electric field, such that significant band bending occurs between the first metal oxide layer 113 and the first side surface 103, which prevents minority carriers from migrating to the first side surface 103, and reduces a concentration of minority carriers at the first side surface 103, thereby being beneficial to reducing a recombination probability of the majority carriers and the minority carriers at the first side surface 103.

It should be noted that a material SiₐO_{b}, a material SiAlᵢOⱼ, and a material XₘOₙ are not strict chemical formulas or chemical structures, and therefore, the material SiₐO_{b}, the material SiAlᵢOⱼ, and the material XₘOₙ may each include one or more stoichiometric compounds and/or one or more non-stoichiometric compounds, where values of "a" and "b" (if present) may be integers or non-integers, values of "i" and "j" (if present) may also be integers or non-integers, and values of "m" and "n" (if present) may also be integers or non-integers. The term "non-stoichiometric compound" means and includes a compound with a certain element composition that cannot be represented by a ratio of clearly defined natural numbers and does not violate a law of definite proportions. The content of each element in the first silicon oxide layer 111, the first silicon metal oxide layer 112, and the first metal oxide layer 113 may be measured and confirmed by using an energy dispersive spectrometer (EDS), an electron energy loss spectroscopy (EELS) or a secondary ion mass spectroscopy (SIMS). For example, a specific linear region or areal region is selected for testing through a measurement device.

In some embodiments, a metal element in the first silicon metal oxide layer 112 may be the same as a metal element in the first metal oxide layer 113, and thus, the first silicon metal oxide layer 112 may be formed based on diffusion of metal atoms in the first metal oxide layer 113 into the first silicon oxide layer 111.

In other embodiments, the metal element in the first silicon metal oxide layer 112 may also be different from the metal element in the first metal oxide layer 113, and thus, the first silicon metal oxide layer 112 and the first metal oxide layer 113 may be formed by different processes respectively.

In some embodiments, a concentration of metal atoms per unit volume in the first metal oxide layer 113 is less than or equal to a concentration of metal atoms per unit volume in the third metal oxide layer 130. On the first side surface 103, the metal atoms in the first metal oxide layer 113 easily diffuse into the first silicon metal oxide layer 112; and on the second side surface 104, due to a high density of the silicon nitride layer 124, a probability of metal atoms in the third metal oxide layer 130 diffusing into the second passivation stack 120 is relatively lower, such that after the first metal oxide layer 113 and the third metal oxide layer 130 are formed by the same process step, a concentration of metal atoms in the first metal oxide layer 113 decreases, and the concentration of metal atoms per unit volume in the first metal oxide layer 113 is less than the concentration of metal atoms per unit volume in the third metal oxide layer 130.

The concentration of metal atoms per unit volume in the first metal oxide layer 113 may range from 0.9E23atoms/cm³ to 1.3E23atoms/cm³, such as 0.9E23atoms/cm³, 1E23atoms/cm³, 1.03E23atoms/cm³, 1.05E23atoms/cm³, 1.08E23atoms/cm³, 1.1E23atoms/cm³, 1.14E23atoms/cm³, 1.16E23atoms/cm³, 1.2E23atoms/cm³, 1.25E23atoms/cm³, or 1.3E23atoms/cm³.

The concentration of metal atoms per unit volume in the third metal oxide layer 130 may range from 0.9E23atoms/cm³ to 1.3E23atoms/cm³, such as 0.9E23atoms/cm³, 1E23atoms/cm³, 1.03E23atoms/cm³, 1.05E23atoms/cm³, 1.08E23atoms/cm³, 1.1E23atoms/cm³, 1.14E23atoms/cm³, 1.16E23atoms/cm³, 1.2E23atoms/cm³, 1.25E23atoms/cm³, or 1.3E23atoms/cm³.

FIG. 6 is a schematic diagram illustrating yet another sectional structure of the segmented solar cell in FIG. 2 along the AA1 direction.

With reference to FIG. 6, in some embodiments, the first main surface 101 is provided with the second silicon oxide layer 121, the second silicon metal oxide layer 122, and the second metal oxide layer 123 sequentially stacked in the direction away from the cell body 100; and the second main surface 102 is provided with the silicon nitride layer 124. In this way, during a process of forming the second silicon oxide layer 121, the second silicon metal oxide layer 122, and the second metal oxide layer 123 on the first main surface 101 of the whole solar cell 1, the second silicon oxide layer 121, the second silicon metal oxide layer 122, and the second metal oxide layer 123 may be formed on the second side surface 104 using winding coating; and during a process of forming the silicon nitride layer 124 on the second main surface 102 of the whole solar cell 1, the silicon nitride layer 124 may be formed on the second metal oxide layer 123 of the second side surface 104 using winding coating, such that the second passivation stack 120 may be prepared during a process of preparing the whole solar cell 1, thereby improving the manufacturing efficiency of the segmented solar cell 10.

A thickness of the second silicon oxide layer 121 on the first main surface 101 may be greater than a thickness of the second silicon oxide layer 121 in the second passivation stack 120. A thickness of the second silicon metal oxide layer 122 on the first main surface 101 may be greater than a thickness of the second silicon metal oxide layer 122 in the second passivation stack 120. A thickness of the second metal oxide layer 123 on the first main surface 101 is greater than a thickness of the second metal oxide layer 123 in the second passivation stack 120. When the second silicon oxide layer 121, the second silicon metal oxide layer 122, and the second metal oxide layer 123 are formed on the second side surface 104 to form the second passivation stack 120, and are also formed on the first main surface 101 using winding coating, a thickness of each layer formed over the second side surface 104 may be less than a thickness of each layer formed over the first main surface 101 due to a relatively small area of the second side surface 104.

Similarly, when the silicon nitride layer 124 on the second side surface 104 is formed using winding coating during a process of forming the silicon nitride layer 124 on the second main surface 102 of the whole solar cell 1, a thickness of the silicon nitride layer 124 on the second main surface 102 may be greater than a thickness of the silicon nitride layer 124 in the second passivation stack 120.

A process of forming the second passivation stack 120 and the third metal oxide layer 130 using winding coating may be as follows: During formation of the whole solar cell 1, first, the second silicon oxide layer 121, the second silicon metal oxide layer 122, and the second metal oxide layer 123 sequentially stacked are formed on the first main surface 101 of the whole solar cell 1, and in this case, the second silicon oxide layer 121, the second silicon metal oxide layer 122, and the second metal oxide layer 123 are formed on a side surface of the whole solar cell 1 using winding coating; and during formation of the silicon nitride layer 124 on the second main surface 102 of the whole solar cell 1, the silicon nitride layer 124 is formed on the second metal oxide layer 123 on a side surface of the whole solar cell 1 using winding coating. When the whole solar cell 1 is subsequently cut into a plurality of segmented solar cells 10, a cut surface formed by cutting serves as the first side surface 103, and an uncut side surface serves as the second side surface 104; and in this case, the second side surface 104 is provided with the second passivation stack 120 composed of the second silicon oxide layer 121, the second silicon metal oxide layer 122, the second metal oxide layer 123, and the silicon nitride layer 124. Then during a process of forming the first passivation stack 110 on the first side surface 103, a plurality of the segmented solar cells 10 are stacked and placed in a deposition box, and the first side surface 103 is exposed; when the first silicon oxide layer 111 is formed by an oxidation process, the first side surface 103 is the bare cell body 100 that is oxidized to form the first silicon oxide layer 111, and the silicon nitride layer 124 is an outermost layer on the second side surface 104 and therefore will not be oxidized; then when the first metal oxide layer 113 is formed, the metal element in the first metal oxide layer 113 on the first side surface 103 diffuses into the first silicon oxide layer 111 to form the first silicon metal oxide layer 112, such that the first silicon oxide layer 111, the first silicon metal oxide layer 112, and the first metal oxide layer 113 form the first passivation stack 110; and simultaneously, a metal oxide layer of a partial thickness, i.e., the third metal oxide layer 130, is also deposited on the second side surface 104.

It should be noted that, as an example, the above forming process is to prepare the second passivation stack 120 using winding coating when passivation film layers are formed on the first main surface 101 and the second main surface 102 of the whole solar cell 1; and the third metal oxide layer 130 is prepared during a process of forming the first metal oxide layer 113 in the first passivation stack 110, which does not limit methods for preparing the second passivation stack 120 and the third metal oxide layer 130. In some other embodiments, the second passivation stack 120 and the third metal oxide layer 130 may be formed by a separate deposition process.

The thickness of the second silicon oxide layer 121, the thickness of the second silicon metal oxide layer 122, and the thickness of the second metal oxide layer 123 on the first main surface 101 are all defined in relation to a thickness direction of the cell body 100. The thickness of the second silicon oxide layer 121, the thickness of the second silicon metal oxide layer 122, and the thickness of the second metal oxide layer 123 in the second passivation stack 120 are all defined in relation to a direction perpendicular to the second side surface 104.

In some embodiments, the thickness of the second silicon oxide layer 121 in the direction perpendicular to the second side surface 104 may be less than the thickness of the first silicon oxide layer 111 in the direction perpendicular to the first side surface 103.

In some embodiments, the thickness of the second silicon metal oxide layer 122 in the direction perpendicular to the second side surface 104 may be less than the thickness of the first silicon metal oxide layer 112 in the direction perpendicular to the first side surface 103.

In some embodiments, the thickness of the second metal oxide layer 123 in the direction perpendicular to the second side surface 104 may be less than the thickness of the first metal oxide layer 113 in the direction perpendicular to the first side surface 103.

The first side surface 103 includes the first passivation stack 110, the second side surface 104 includes the second passivation stack 120 and the third metal oxide layer 130, and the number of film layers on the second side surface 104 is at least greater than the number of film layers on the first side surface 103; and compared with the first side surface 103 with the single first passivation stack 110, the second side surface 104 achieves a relatively better passivation effect, and therefore, even if a thickness of each film layer in the second passivation stack 120 on the second side surface 104 is relatively less than a thickness of each film layer in the first passivation stack 110 on the first side surface 103, the second side surface 104 still maintains a good passivation effect.

The thickness of the second silicon oxide layer 121 in the direction perpendicular to the second side surface 104 may range from 0.5 nm to 5 nm, such as 0.5 nm, 1 nm, 1.5 nm, 2 nm, 2.5 nm, 3 nm, 3.5 nm, 4 nm, 4.5 nm, or 5 nm.

The thickness of the second silicon metal oxide layer 122 in the direction perpendicular to the second side surface 104 may range from 0.5 nm to 5 nm, such as 0.5 nm, 1 nm, 1.5 nm, 2 nm, 2.5 nm, 3 nm, 3.5 nm, 4 nm, 4.5 nm, or 5 nm.

The thickness of the second metal oxide layer 123 in the direction perpendicular to the second side surface 104 may range from 1 nm to 60 nm, such as 1 nm, 5 nm, 10 nm, 15 nm, 20 nm, 25 nm, 30 nm, 35 nm, 40 nm, 45 nm, 50 nm, 55 nm, or 60 nm.

For a material of the second silicon oxide layer 121, a material of the second silicon metal oxide layer 122, and a material of the second metal oxide layer 123, reference may be made to the material of the first silicon oxide layer 111, the material of the first silicon metal oxide layer 112, and the material of the first metal oxide layer 113 described above, which will not be described in detail herein.

In some embodiments, a concentration of metal atoms per unit volume in the second metal oxide layer 123 on the second side surface 104 may be less than the concentration of metal atoms per unit volume in the first metal oxide layer 113. Compared with the first side surface 103 with the single first passivation stack 110, the second side surface 104 achieves a relatively better passivation effect, and therefore, even if the concentration of metal atoms per unit volume in the second metal oxide layer 123 on the second side surface 104 is less than the concentration of metal atoms per unit volume in the first metal oxide layer 113, the second side surface 104 still maintains a good passivation effect.

The concentration of metal atoms per unit volume in the second metal oxide layer 123 may range from 0.9E23atoms/cm³ to 1.3E23atoms/cm³, such as 0.9E23atoms/cm³, 1E23atoms/cm³, 1.03E23atoms/cm³, 1.05E23atoms/cm³, 1.08E23atoms/cm³, 1.1E23atoms/cm³, 1.14E23atoms/cm³, 1.16E23atoms/cm³, 1.2E23atoms/cm³, 1.25E23atoms/cm³, or 1.3E23atoms/cm³.

The segmented solar cell 10 provided in the embodiments of the present disclosure is formed by cutting the whole solar cell 1, the segmented solar cell 10 includes the cell body 100, the first main surface 101 of the cell body 100 is one of a front surface and a back surface thereof, and the second main surface 102 is the other of the front surface and the back surface; the first side surface 103 is the cut surface of the segmented solar cell 10 formed by cutting the whole solar cell 1, the second side surface 104 is the uncut side surface from the whole solar cell 1, the first side surface 103 is provided with the first passivation stack 110 composed of the first silicon oxide layer 111, the first silicon metal oxide layer 112, and the first metal oxide layer 113, the first silicon oxide layer 111 chemically passivates the cut surface (i.e., the first side surface 103), and oxygen atoms thereof saturate the dangling bonds on the cut surface to reduce a defect state density of the cut surface and reduce a carrier recombination probability by minimizing a recombination center on the cut surface; the metal element in the first metal oxide layer 113 provides high-density fixed charges, which generates a large electric field, achieves a good field passivation effect on the cut surface, reduces a concentration of minority carriers at the cut surface, and further reduces a recombination probability of majority carriers and minority carriers at the cut surface; and the first silicon metal oxide layer 112 serves as a transition layer between the first silicon oxide layer 111 and the first metal oxide layer 113, which improves a lattice matching degree at an interface where the first silicon oxide layer 111, the first silicon metal oxide layer 112, and the first metal oxide layer 113 come into contact with each other sequentially, prevents pores generation and dislocation at the contact interface, enhances the uniformity of the first passivation stack 110, and further improves an passivation effect of the first passivation stack 110 on the cut surface. The second side surface 104 is further provided with the second passivation stack 120 similar to the first passivation stack 110; and the second silicon oxide layer 121, the second silicon metal oxide layer 122, and the second metal oxide layer 123 in the second passivation stack 120 have a same mechanism of action as the first passivation stack 110, which enables to passivate the side surface of the segmented solar cell 10 not cut from the whole solar cell 1, and further reduces an impact of mechanical damage and dangling bonds caused by cutting of the wafer on the efficiency of the segmented solar cell 10. The second passivation stack 120 further includes the silicon nitride layer 124, and the silicon nitride layer 124 has advantages of a high specific strength, a high specific modulus, high temperature resistance, oxidation resistance, wear resistance, and thermal shock resistance, and is capable of protecting the second passivation stack 120 from the influence of other processes. The third metal oxide layer 130 is formed on a surface of the second passivation stack 120 away from the cell body 100, and a metal element in the third metal oxide layer 130 is the same as a metal element in the first metal oxide layer 113, such that the third metal oxide layer 130 and the first metal oxide layer 113 may be formed by means of a same process step, and the third metal oxide layer 130 further improves the passivation effect of the side surface of the segmented solar cell 10 not cut from the whole solar cell 1, which is beneficial to further improving the efficiency of the segmented solar cell.

Correspondingly, a photovoltaic module is provided in some embodiments of the present disclosure, including: a plurality of segmented solar cells, each segmented solar cell of the plurality of the segmented solar cells is the segmented solar cell as described in the above embodiments. The photovoltaic module will be described in detail below in conjunction with the accompanying drawings. For the description identical or corresponding to the previous embodiment, reference can be made to the corresponding description in the foregoing embodiments, and details are not described again herein.

FIG. 7 is a schematic structural diagram illustrating a photovoltaic module provided in some embodiments of the present disclosure.

With reference to FIG. 7, the photovoltaic module includes: a plurality of segmented solar cells, where each segmented solar cell of the plurality of the segmented solar cells is the segmented solar cell 10 as described in the above embodiments, connection components 201, at least one encapsulant film 202, and at least one cover plate 203. Each of the connection components 201 is configured to connect two adjacent segmented solar cells 10 of the plurality of the segmented solar cells. The at least one encapsulant film 202 is configured to cover surfaces of the plurality of segmented solar cells 10. The at least one cover plate 203 is configured to cover at least one surface of the at least one encapsulant film 202 away from the plurality of segmented solar cells 10.

Each of the connection components 201 includes an interconnection ribbon and a busbar ribbon, where the interconnection ribbon mainly includes a conventional flat ribbon, a multi-busbar (MBB) ribbon, a low-temperature ribbon, a low-resistance ribbon, a special-shaped ribbon, and the like; and the busbar ribbon mainly includes a conventional busbar ribbon, a punched ribbon, a black ribbon, a bent ribbon, and the like.

The encapsulant film 202 may be an organic encapsulation film such as an ethylene-vinyl acetate copolymer (EVA) film, a polyethylene octene copolymer elastomer (POE) film or a polyvinyl butyral (PVB) film.

The cover plate 203 may be a light-transmitting cover plate such as a glass cover plate or a plastic cover plate. In some embodiments, a surface of the cover plate 203 facing the encapsulant film 202 may be a textured surface, thereby enhancing the utilization of incident light.

It should be noted that FIG. 7 shows an example in which positive grid lines and negative grid lines of the segmented solar cell 10 are respectively formed on two sides of the segmented solar cell 10, and in this case, one end of one respective connection component 201 is located on a front surface of a segmented solar cell 10, and the other end thereof is located on a back surface of another segmented solar cell 10, which does not constitute a limitation of the segmented solar cells 10. In some other embodiments, the segmented solar cell may also be a back-contact solar cell, and in this case, the positive grid lines and the negative grid lines of the segmented solar cell are both formed on a same side of the segmented solar cell, and two ends of one respective connection component are located on a same side of two adjacent segmented solar cells.

In the photovoltaic module provided in some embodiments of the present disclosure, the segmented solar cell is formed by cutting a whole solar cell, and includes a cell body having a first main surface, a second main surface, and a first side surface and second side surfaces connecting the first main surface and the second main surface, a first passivation stack formed on the first side surface, and a second passivation stack formed on at least one second side surface of the second side surfaces. The first side surface refers to a cut surface formed by cutting the whole solar cell, and the second side surfaces refer to uncut side surfaces. The segmented solar cell further includes a third metal oxide layer formed on the second passivation stack. In this way, the cut surface of the segmented solar cell formed by cutting the whole solar cell is passivated by the first passivation stack, and at least one uncut side surface of the segmented solar cell having mechanical damage and dangling bonds caused by cutting of wafer is passivated by the second passivation stack and the third metal oxide layer, which is beneficial to further improving the efficiency of the photovoltaic module.

It may be understood by those skilled in the art that the above embodiments are particular embodiments to implement the present disclosure, and in a practical application, various changes can be made to the form and details without departing from the spirit and scope of the present disclosure. Various alterations and modifications may be made by a person skilled in the art without departing from the scope of the present disclosure, and therefore, with regard to the scope of protection of the present disclosure, the scope defined in the claims shall prevail.

## Claims

1. A segmented solar cell (10) formed by cutting a whole solar cell (1), comprising:
a cell body (100) including a first main surface (101) and an opposing second main surface (102), and a first side surface (103) and a second side surface (104) connecting the first main surface (101) and the second main surface (102), respectively, wherein the first side surface (103) refers to a cut surface formed by cutting the whole solar cell (1), and the second side surface (104) refer to an uncut side surface;
a first passivation stack (110) formed on the first side surface (103), wherein the first passivation stack (110) includes a first silicon oxide layer (111), a first silicon metal oxide layer (112), and a first metal oxide layer (113) stacked along a first direction away from the cell body (100); and
a second passivation stack (120) formed on the second side surface (104), wherein the second passivation stack (120) includes a second silicon oxide layer (121), a second silicon metal oxide layer (122), a second metal oxide layer (123), and a silicon nitride layer (124).

2. The segmented solar cell (10) according to claim 1, further including a third metal oxide layer (130) formed on a surface of the second passivation stack (120) away from the cell body (100), wherein the third metal oxide layer (130) includes a metal element same as that in the first metal oxide layer (113).

3. The segmented solar cell (10) according to claim 2, wherein concentration of metal atoms per unit volume in the first metal oxide layer (113) is less than or equal to concentration of metal atoms per unit volume in the third metal oxide layer (130).

4. The segmented solar cell (10) according to any one of claims 1 to 3, wherein the second side surface (104) is perpendicular to the first main surface (101) or the second main surface (102), and the first side surface (103) forms an acute angle with the first main surface (101) and an obtuse angle with the second main surface (102).

5. The segmented solar cell (10) according to claim 4, wherein the first metal oxide layer (113) has a first thickness at the acute angle and a second thickness at the obtuse angle, and the first thickness is greater than or equal to the second thickness.

6. The segmented solar cell (10) according to claim 5, wherein a difference between the first thickness and the second thickness ranges from 0 nm to 5 nm.

7. The segmented solar cell (10) according to any one of claims 1 to 6, wherein the second silicon oxide layer (121), the second silicon metal oxide layer (122), and the second metal oxide layer (123) are further formed over the first main surface (101) and stacked along a second direction away from the cell body (100); and
the silicon nitride layer (124) is further formed on the second main surface (102).

8. The segmented solar cell (10) according to claim 7, wherein
the second silicon oxide layer (121) formed on the first main surface (101) has a thickness greater than a thickness of the second silicon oxide layer (121) of the second passivation stack (120), the second silicon metal oxide layer (122) formed over the first main surface (101) has a thickness greater than a thickness of the second silicon metal oxide layer (122) of the second passivation stack (120), and the second metal oxide layer (123) formed over the first main surface (101) has a thickness greater than a thickness of the second metal oxide layer (123) of the second passivation stack (120); and/or
the silicon nitride layer (124) formed on the second main surface (102) has a thickness greater than a thickness of the silicon nitride layer (124) of the second passivation stack (120).

9. The segmented solar cell (10) according to any one of claims 1 to 6, wherein the second silicon oxide layer (121) has a thickness less than a thickness of the first silicon oxide layer (111), the second silicon metal oxide layer (122) has a thickness less than a thickness of the first silicon metal oxide layer (112), and the second metal oxide layer (123) has a thickness less than a thickness of the first metal oxide layer (113).

10. The segmented solar cell (10) according to claim 9, wherein the thickness of the first silicon oxide layer (111) ranges from 1 nm to 10 nm, the thickness of the first silicon metal oxide layer (112) ranges from 1 nm to 15 nm, the thickness of the first metal oxide layer (113) ranges from 10 nm to 100 nm, the thickness of the second silicon oxide layer (121) ranges from 0.5 nm to 5 nm, the thickness of the second silicon metal oxide layer (122) ranges from 0.5 nm to 5 nm, and the thickness of the second metal oxide layer (123) ranges from 1 nm to 60 nm.

11. The segmented solar cell (10) according to any one of claims 1 to 6, wherein concentration of metal atoms per unit volume in the second metal oxide layer (123) is less than concentration of metal atoms per unit volume in the first metal oxide layer (113).

12. The segmented solar cell (10) according to claim 11, wherein the concentration of metal atoms per unit volume in the second metal oxide layer (123) ranges from 0.9E23atoms/cm³ to 1.3E23atoms/cm³, and the concentration of metal atoms per unit volume in the first metal oxide layer (113) ranges from 0.9E23atoms/cm³ to 1.3E23atoms/cm³.

13. The segmented solar cell (10) according to any one of claims 1 to 12, wherein the first silicon oxide layer (111) includes an SiₐO_{b} material, and a/b is in a range from 1.5 to 49, wherein a/b represents a ratio of content of silicon to content of oxygen in the first silicon oxide layer (111).

14. The segmented solar cell (10) according to any one of claims 1 to 13, wherein at least one of the first main surface (101) and the second main surface (102) has a textured structure.

15. A photovoltaic module, comprising:
a plurality of segmented solar cells, wherein each segmented solar cell of the plurality of the segmented solar cells is the segmented solar cell (10) according to any one of claims 1-14;
connection components (201), wherein each connection component of the connection components (201) is configured to connect two adjacent segmented solar cells of the plurality of the segmented solar cells;
at least one encapsulant film (202) configured to cover surfaces of the plurality of segmented solar cells; and
at least one cover plate (203) configured to cover at least one surface of the at least one encapsulant film (202) away from the plurality of segmented solar cells.
